# EUROPEAN PATENT SPECIFICATION

(11) **EP 0 401 348 B1**
(45) Date of publication and mention of the grant of the patent: **30.03.1994**
(21) Application number: 90900775.9
(22) Date of filing: 22.12.1989
(51) Int. Cl.: D06L 1/10

(54) **METHOD OF PURIFYING DRY-CLEANING SOLVENT**
REINIGUNG EINES LÖSUNGSMITTELS FÜR CHEMISCHE REINIGUNG
PROCEDE DE PURIFICATION DE SOLVANT DE NETTOYAGE A SEC

(30) Priority: 23.12.1988 JP 3237/89
(43) Date of publication of application: 12.12.1990
(73) Proprietor: NOVO NORDISK A/S, 2880 Bagsvaerd (DK)
(72) Inventor: ABO, Masanobu, Chiba-ken 274 (JP)
(86) International application number: PCT/DK89/00308
(87) International publication number: WO 90/07606

(56) References cited:
- US-A- 3 619 120
- US-A- 4 193 765
- US-A- 4 312 633
- CHEMICAL ABSTRACTS, vol. 101, no. 2, 9 July 1984, Columbus, Ohio, US; Martirosyan G.G. et al.: "Purifiying organic solvents", see page 101, abstract 9135j; & Otkrytiya Izobret., Prom. Obraztsy, Tovarnye Znaki 1984, (3), 78.

## Description

The present invention relates to a method of removing contaminants, especially neutral lipid contaminants, from a solvent which has been used for dry cleaning, by using a lipase.

Solvents used for dry cleaning are commonly re-used after removal of contaminants by filtration and adsorption. However, non-polar neutral lipid contaminants are poorly adsorbed and are highly soluble in the solvent, and they are therefore difficult to remove.

It is the purpose of the present invention to provide a purification method that can readily remove contaminants containing non-polar neutral lipid from a solvent that has been used for dry cleaning.

The above-mentioned problem is solved by a purification method characterized by placing used solvent in contact with a lipase, which is producible by cultivation of a microorganism belonging to the genus Candida, Humicola, Pseudomonas or Mucor, or by cultivation of a genetic recombinant of the lipase, or with an immobilized product of said lipase, and with an adsorbent.

Lipase produced by a microorganism belonging to the genus Candida, Humicola, Pseudomonas or Mucor or lipases produced by a transformant obtained by inserting the structural gene for said lipase into another microorganism can be used advantageously.

Generally, enzymes do not show their activities in organic solvents because they undergo denaturation. However, it was surprisingly found that some lipases show activity even in dry cleaning solvents. For example, lipases derived from Candida antarctica, Humicola lanuginosa and Pseudomonas fluorescens show activity even in dry cleaning solvents. The present invention is based on this discovery. Neutral lipid contaminants dissolved in solvents are decomposed by lipases and the resulting fatty acid and glyceride products are easily adsorbed on the adsorbents.

The lipase can be added in the form of an aqueous solution to the solvents used for dry cleaning, but may possibly recontaminate the clothes to be cleaned. Consequently, it is desirable to use the lipase in the form of immobilized lipase. Any known method can be used for the immobilization of the lipase. For example, the immobilization can be done by gel entrapment e.g. in polyacrylamide or alginate, by adsorption e.g. on silica or alumina, by cross-linking with glutaraldehyde, or by adsorption on ion exchange resin. (The details for the immobilization are described, for example, in "Immobilized enzymes" written by Dr. Ichiro Chibata, published in 1975 by Kodansha Ltd.).

The contact between immobilized lipase and solvent is conveniently effected by use of a cartridge wherein the immobilized lipase is retained, while the solvent is allowed to flow through. Optionally, the cartridge may contain an adsorbent together with the immobilized lipase. Filter paper, filter cloth or other porous sheet material may be used to retain the immobilized lipase. The cartridge may allow the solvent to be pumped through; e.g. it may be cylindrical and have an inner tube and an outer, annular speace for solvent inlet and outlet. Or the cartridge may consist of a bag of porous material containing the immobilized lipase (and, optionally adsorbent), suited for dropping into a solvent tank.

The lipase may be a lipase produced by the original microorganism, or it may be a lipase produced by a transformant produced by inserting the structural gene for a lipase into another microorganism. Said gene transformant can be produced by generally known methods. Details are described, for example, in Idenshi Kogaku (Genetic Engineering), Volume 8 of Biseibutsu-gaku Kiso Koza (Basic Microbiological Seminars), edited by Tadahiko Ando and Kenji Sakaguchi, published in 1987 by Kyoritsu Shuppan Co., Ltd. and in Idenshi Kenkyuho (Genetic Laboratory Methods) II, Volume 1 of Zoku-Seikagaku Jikken Koza (Sequel of Biochemical Experiment Seminar), edited by Japan Society of Biochemistry, published in 1986 by K.K. Tokyo Kagaku Dojin).

Some lipases which can be used for the practice of the present invention are commercially available. Some examples of suitable lipases are listed below.
(A) Immobilized Mucor miehei lipase (Lipozyme®, product of Novo-Nordisk A/S, Denmark).
(B) Lipase derived from Humicola lanuginosa (SP-400, product of Novo-Nordisk A/S, Denmark). This lipase is described in the JP-A 63-68697.
(C) Lipase derived from Candida antarctica, described in WO 88/02775.
(D) Lipase derived from Pseudomonas fluorescens (product of Amano Pharmaceutical Co., Ltd.).
(E) Lipase derived from Pseudomonas cepacia, described in the JP-A 62-34997, and the immobilized form of this enzyme (product of Novo-Nordisk A/S, Denmark), described in WO 89/01032.

The dry cleaning solvent may e.g. trichloro-ethane, tetrachloro-ethylene, a hydrocarbon solvent (e.g. gasoline No. 5) or a fluorinated hydrocarbon (e.g. Freon F-11 or F-113). The method of the invention is effective with any of these solvents.

The method for putting the solvent used for dry cleaning into contact with lipase or immobilized lipase and with adsorbent is not specially restricted; the lipase or immobilized lipase can be used in a conventional method for adsorption using adsorbent. A particularly advantageous method consists in throwing into a tank with solvent a cartridge in which immobilized lipase in combination with adsorbent is contained in a vessel.

The adsorbents to be used for the present invention are not especially restricted. For example, activated carbon powder and alumina silica gel can be used advantageously.

The amount of lipase or immobilized lipase is preferably within the range of 1 - 50 weight percent of the solvent, and the amount of adsorbent is preferably within the range of 10 - 60 weight percent of the solvent. The ratio between the lipase or immobilized lipase and the adsorbent is preferably within the range of 1/1 - 1/100.

The purification method of the present invention will be explained hereinafter by way of working examples.

### EXAMPLE 1

An excess of lipase derived from Humicola lanuginosa (SP 400, a product of Novo-Nordisk A/S) was added to 20 g of porous ceramic (a product of Showa Kogyo Co., Ltd.) in such a manner that it was entirely submerged into the lipase solution and the mixture was left standing overnight so as to adsorb and immobilize the enzyme into the ceramic. The excess enzyme was removed by repeated washing with water and finally the ceramic was washed with ethanol, which was dried in vacuo, by which the immobilized enzyme could be obtained. The moisture content in the immobilized enzyme thus obtained, determined with an infrared hygrometer, was less than 0.5 weight percent. By determination with a synthetic substrate it was found that the activity of the immobilized enzyme was 40.9 units per gram.

The activity of the immobilized enzyme was determined in the following manner. Into 3 ml of 50 mM Tris hydrochloric acid buffer (pH 8.5), 0.45 ml of an ethanolic solution containing 10 mg of immobilized enzyme and 1 mmol of para-nitrophenyl capronate was added, and the increase in the absorbance was determined with a wave length of 400 nanometer. One unit was defined herein as the amount of enzyme which can release 1 micromol of para-nitrophenol in one minute.

The hydrolysis of olive oil in trichloroethane was conducted using the above-mentioned immobilized enzyme. In this process, water should be supplied in a certain amount because it is one of the substrates involved. For this reason, the immobilized enzyme was hydrated overnight in advance by adding 55 weight percent of water. The test sample used was 10 g of olive oil in 70 ml of trichloroethane, and 10 ml each of the mixture was distributed into 4 test tubes with tight stoppering. Into the test tubes Nos. 3 and 4, one gram each of the immobilized enzyme was added, and the mixtures were each reacted for 19 hours with gentle stirring. The test tubes Nos. 1 and 2 were left standing intact as controls. At 19 hours, 2 g each of a commercial adsorbent for dry cleaning (Alumina silica gel "Sekard®", a product of Shinagawa Kasei Co., Ltd., Japan) was added into the test tubes Nos. 2 and 4. And the stirring was further continued for another 3 hours. One ml was collected from each of these test tubes, and 10 ml each of chloroform containing 15 weight percent of lithocolic acid as internal standard was added. The contents of triglycerides (TG), diglycerides (DG) and fatty acids in these test samples were quantitatively assayed with Iatroscan (a product of Iatron Co., Ltd., Japan).

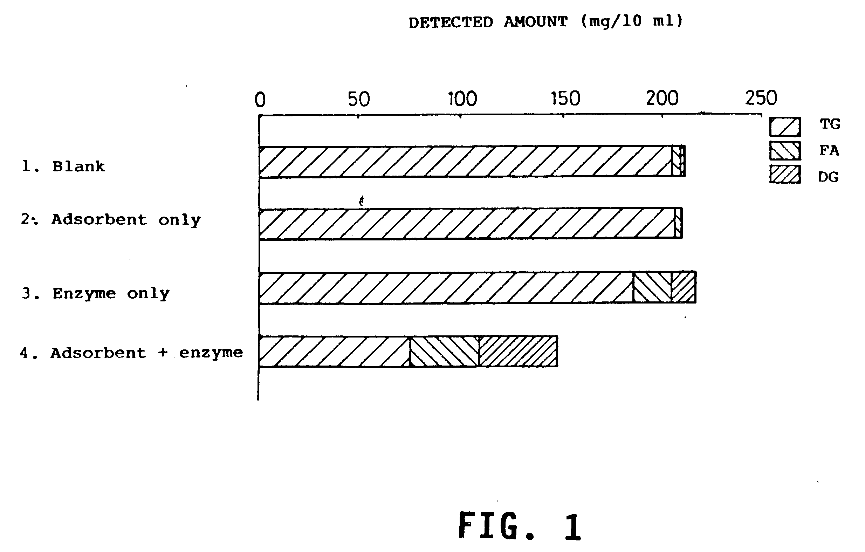

The results were as illustrated in Fig. 1. The number 1 in the chart represents the intact test sample (for comparison), while the numbers 2, 3 and 4 represent the test samples with only adsorbent (for comparison), the sample with only enzyme (for comparison), and the sample treated with both immobilized enzyme and adsorbent (sample according to the present invention), respectively. As clearly seen in Fig. 1, triglycerides cannot be adsorbed at all when only adsorbent is added to the olive oil solution. When immobilized enzyme was added, the amounts of diglycerides and fatty acids were found to increase, showing that hydrolysis proceeded. The relatively low reaction rate can possibly be attributed to equilibrium being reached because of the low solubilities of diglycerides and fatty acids (as the reaction products) in trichloroethane. When both adsorbent and immobilized enzyme were used, the reaction products were adsorbed and the equilibrium moved to the side of hydrolysis, so that the hydrolysis remarkably advanced and the lipids in the solvent were remarkably reduced.

As clearly seen from this example, the method claimed by the present invention enables the decomposition of neutral lipids retained in used dry cleaning solvent into fatty acids and diglycerides, and these reaction products can be easily adsorbed on an adsorbent, which can be easily removed. Especially to be noted is that the adsorbent and lipase work with each other in a synergistic manner. More specifically, when the adsorbent and lipase are used together, the reaction products are adsorbed and the equilibrium moves to the side of hydrolysis, whereby the hydrolysis is enhanced and the amount of lipid in the solvent is remarkably reduced.

Fig. 1 illustrates the effects of the method claimed by the present invention (using immobilized lipase and the adsorbent) for removal of neutral lipids.

### EXAMPLE 2

Olive oil degradation in trichloro ethylene tried using Lipozyme. Lipozyme was hydrated with 60% water (w/w) overnight. One gram of olive oil was dissolved in 100 ml trichloro ethylene. 20 ml of this solution was taken into each of two flasks. One gram of Lipozyme was added to one flask and 1 g each of Lipozyme and adsorbent were added to the other. The reaction mixture was kept for 24 hours. One ml aliquot was taken from the reaction mixture, and 10 ml chloroform containing 0.5% (w/v) lithocholic acid was added as an internal standard. The amount of triglyceride, diglyceride and fatty acid in each sample was analyzed by Iatroscan. The result is shown in the table.

| Sample | TG (mg) | DG (mg) (in 10 ml sample) | FA (mg) |
|---|---|---|---|
| No treatment | 68.4 | 0 | 33.4 |
| Enzyme treatment | 36.4 | 0 | 46.5 |
| Enzyme + adsorbent | 18.1 | 0 | 34.6 |

The reason why the amount of TG was decreased and FA was increased in the enzyme treated sample compared with the non-treated sample is that the anion exchange resin which is used as a carrier of Lipozyme adsorbed some FA produced by hydrolysis. Total amount of TG and FA was decreased to approx. 80% compared to the non-treated sample. When adsorbent was added together with enzyme the total amount was reduced to approx. 50%.

### EXAMPLE 3

Olive oil degradation in 1,1,2-trichloro-1,2,2-trifluoroethane (freon 113) was tried using Lipase P "Amano". One gram of olive oil was dissolved in 50 ml freon 113. One ml of 5% solution of Lipase P "Amano" and 4 g of adsorbent were added to the 20 ml of olive oil/freon 113. The reaction mixture was kept for 16 hours. One ml aliquot was taken from the reaction mixture, and 10 ml chloroform containing 0.5% (w/v) lithocholic acid was added as an internal standard. The amount of triglyceride, diglyceride and fatty acid in each sample was analyzed by Iatroscan. An untreated sample was analyzed in the same way. It was found that TG had completely disappeared after the treatment, and the amount of FA was less than 10% of original amount of TG and FA.

## Claims

1. A method of purifying a solvent which has been used for dry cleaning, characterized in that the solvent is placed in contact with a lipase, which is produced by cultivation of a microorganism belonging to the genus Candida, Humicola, Pseudomonas, or Mucor, or by cultivation of a genetic recombinant of the lipase, or with an immobilized product of said lipase, and with an adsorbent.

2. A method according to Claim 1, wherein the purification is effected by placing in the solvent a cartridge through which said solvent may flow, said cartridge containing said lipase, wherein said lipase is an immobilized lipase, in combination with said adsorbent.

3. A cartridge for purifying dry cleaning solvent which comprises a container through which solvent may flow having enclosed therein an immobilized lipase in combination with an adsorbent.

4. A cartridge according to claim 3, wherein the adsorbent is activated carbon powder or alumina silica gel.

## Patentansprüche

1. Ein Verfahren zur Reinigung eines Lösungsmittels, das zur chemischen Reinigung verwendet worden ist, dadurch gekennzeichnet, daß das Lösungsmittel in Kontakt gebracht wird mit einer Lipase, die hergestellt ist durch Kultivierung eines Mikroorganismus, der zur Gattung Candida, Humicola, Pseudomonas oder Mucor gehört, oder durch Kultivierung eines genetischen Rekombinanten der Lipase, oder mit einem immobilisierten Produkt besagter Lipase, und mit einem Adsorptionsmittel.

2. Ein Verfahren nach Anspruch 1, wobei die Reinigung dadurch bewirkt wird, daß eine Patrone in das Lösungsmittel gegeben wird, durch die besagtes Lösungsmittel hindurchströmen kann, wobei besagte Patrone besagte Lipase enthält, wobei besagte Lipase eine immobilisierte Lipase in Kombination mit besagtem Adsorptionsmittel ist.

3. Eine Patrone zur Reinigung von Lösungsmittel für chemische Reinigung, die einen Behälter umfaßt, durch den Lösungsmittel hindurchströmen kann, wobei darin eine immobilisierte Lipase in Kombination mit einem Adsorptionsmittel eingeschlossen ist.

4. Eine Patrone nach Anspruch 3, wobei das Adsorptionsmittel Aktivkohlepulver oder Aluminiumoxid-Silika-Gel ist.

## Revendications

1. Un procédé de purification d'un solvant ayant servi au nettoyage à sec, caractérisé en ce que le solvant est mis en contact avec une lipase qui est produite par culture d'un micro-organisme appartenant au genre Candida Humicola, Pseudomonas ou Mucor ou par culture d'un recombinant génétique de la lipase ou avec un produit immobilisé de ladite lipase et avec un adsorbant.

2. Un procédé selon la revendication 1, dans lequel la purification s'effectue par mise en place dans le solvant d'une cartouche à travers laquelle peut s'écouler ledit solvant, ladite cartouche contenant ladite lipase, dans laquelle ladite lipase est une lipase immobilisée, en combinaison avec ledit adsorbant.

3. Une cartouche pour la purification d'un solvant pour nettoyage à sec qui comprend un récipient à travers lequel peut s'écouler le solvant, dans lequel se trouve enfermée une lipase immobilisée en combinaison avec un adsorbant.

4. Une cartouche selon la revendication 3, dans laquelle l'adsorbant est de la poudre de charbon activée ou un gel d'alumine-silice.
